# EUROPEAN PATENT SPECIFICATION

(11) **EP 3 954 498 B1**
(45) Date of publication and mention of the grant of the patent: **19.07.2023**
(21) Application number: 21190621.9
(22) Date of filing: 10.08.2021
(51) Int. Cl.: B23Q 1/38, B23Q 1/01, B23Q 39/02, F16C 29/00, F16C 29/02, F16C 32/06, G03F 7/20

(54) **HIGH ACCURACY SLIDING ASSEMBLY FOR A MANUFACTURING MACHINE, AND MANUFACTURING MACHINE COMPRISING AT LEAST ONE SUCH ASSEMBLY**
HOCHPRÄZISE GLEITANORDNUNG FÜR EINE FERTIGUNGSMASCHINE UND FERTIGUNGSMASCHINE MIT MINDESTENS EINER SOLCHEN ANORDNUNG
ENSEMBLE COULISSANT HAUTE PRÉCISION POUR UNE MACHINE DE FABRICATION ET MACHINE DE FABRICATION COMPRENANT AU MOINS UN TEL ENSEMBLE

(30) Priority: 11.08.2020 EP 20190394
(43) Date of publication of application: 16.02.2022
(73) Proprietor: C2'M INVEST, 83150 Bandol (FR)
(72) Inventor: Meunier, Patrick, 51010 Massa e Cozzile (PT) (IT)
(74) Representative: Schmidt, Martin Peter

(56) References cited:
- JP-A- 2001 173 654
- JP-A- 2004 156 772
- JP-A- 2007 180 283
- US-A1- 2002 034 345
- US-A1- 2014 227 056
- US-B1- 6 628 435

## Description

### Technical field of the invention

The present invention relates to a sliding assembly, which is intended to equip a high accuracy manufacturing machine. According to the invention, such a manufacturing machine is typically a Computer Numerical Control (CNC) machine. By way of examples this type of CNC machines encompasses machines for the manufacturing of fine optical elements. In this respect, these elements are intended for several industrial applications, in particular medical uses or spatial purposes. These elements are also suitable for ultra-precision technologies which are similar to optics, such as polished free components.

### Prior art

A sliding assembly of the above type generally comprises first a so-called base or reference table, which defines in particular a so-called reference plane. In normal use, this plane is generally horizontal. Moreover, said assembly also comprises at least one slider, also called sliding member. Said slider is movable with respect to the reference plane of the table. In this respect, each slider is provided with moving and positioning means, in particular based on linear motor and encoder technology.

The invention more particularly focuses on sliders which can be moved with respect to the table, along one single direction. Typically, the assembly may comprise two or three distinct sliders, each movable along one respective direction (X, Z and Y).

It is easy to understand that a proper processing of the above type of machines requires a particularly high accuracy, for what concerns the displacement of the slider with respect to the table. In this respect, the positioning of the slider along reference planes must be perfectly controlled. In addition, the positioning of this slider above the table, must also be controlled. So as to ensure the control of these different positions, a sliding assembly also comprises specific bearings.

According to a first possibility, said bearings may use liquid lubricant, such as pressurised oil. In this respect a thin film of said lubricant is provided between the facing surfaces of both the table and the slider. This type of bearings brings about a very satisfactory accuracy. However, they have some drawbacks, which are in particular due to the handling of this liquid lubricant linked to clean environmental conditions where the machine is being used.

Due to the drawbacks of liquid bearings, the present invention mainly focuses on so-called pneumatic or air bearings. The latter use compressed gas, in particular compressed air, to create a consistent thin film upon which the slider rests and moves. This film acts as a virtually frictionless lubricant that facilitates smooth motion between the table and the slider.

Typically, such air bearings provide a number of advantages. First, they are virtually frictionless, and therefore produce no particulate wear materials as they operate. Moreover, they require relatively little maintenance or regular repair, in particular in view of all bearings.

A first type of sliding assembly equipped with air bearings uses fixed parallel rods, along which moves a sliding member. Air bearings are provided at the interface between the rods and the sliding member. Due to space needed between rods and sliding member, this first solution is not satisfactory since it does not make it possible to reach the required high accuracy of the sliding member.

According to further solution, the mobile sliding member is wrapped around a fixed guiding member. The latter may be dovetail shaped, T shaped, or substantially square shaped.

Sliding assembly may use linear motors. In this respect, the fixed part of the sliding assembly and the moving sliding member are provided with respectively fixed and mobile linear motor elements. This solution also uses encoding means, so as to control the mutual positioning of the different components of the assembly.

The above prior technologies may be illustrated by the following references: EP 1 235 115 B1, JP 2019 019826, US 7642523 B1 and EP 2 109 003 B1.

In addition, JP 2001 173 654 discloses a hydrostatic bearing, which comprises a massive hyperstatic slider which is parallelepiped like shaped. This slider is adapted to slide immediately above the upper surface of a base table. The teaching of this document however implies some drawbacks, first linked to mechanical complexity. Indeed, due to its massive shape, the slider cannot cooperate with the peripheral faces of the table. It is therefore necessary to provide some extra fixed supports, protruding with respect to the table, along which the slider may move. Moreover, the arrangements proposed in this document do not make it possible, to reach necessary stability.

Finally, JP 2007 180 283 discloses a lithography system which comprises a mechanism for guiding a movable structure such as the mask blade of a reticle masking device, a movable component connected with the movable structure, and a substantially stationary component for guiding the movable component. The movable component includes nozzles for injecting gas into the gap between the movable component and the stationary component. The guiding mechanism, proposed in this document, has however specific drawbacks. Indeed it is adapted to allow only motions of little stroke, and not higher amplitude motions such as aimed in the present invention.

As a conclusion, none of the previously proposed air bearings makes it possible to reach the high accuracy of oil bearings. In particular known air bearing assemblies do not permit to reach the required stability of low needed values of yaw, pitch, and roll, during the displacements of each sliding member.

Under these circumstances, one first goal of the invention is to remedy to the drawbacks of the above detailed prior art.

Another goal of the invention is to provide a high accuracy sliding assembly which uses air bearings, while allowing a displacement accuracy which is similar to that of oil bearings.

Another goal of the invention is to provide such sliding assembly, which benefits of the same advantages as those of prior air bearings.

A further goal of the invention is to provide a sliding assembly, which has a very satisfactory stability, during its motion.

Still another goal of the invention is to provide such a sliding assembly having a relatively simple structure, in particular including a limited number of mechanical components.

### Objects of the invention

One object of the present invention is a sliding assembly according to appended claim 1.

Advantageous features of this sliding assembly are recited in appended claims 2 to 14.

Another object of the invention is a manufacturing machine according to appended claim 15.

### Description of the figures

Figure 1 is a perspective view, showing a manufacturing machine equipped with a high accuracy sliding assembly according to a first embodiment of the invention.
Figure 2 is a perspective view, showing a base table which forms part of the high accuracy sliding assembly of figure 1.
Figure 3 is a front view along arrow III, showing the base table of figure 2.
Figure 4 is an end view along arrow IV, showing the base table of figure 2.
Figure 5 is a perspective view, showing a first sliding member which forms part of the high accuracy sliding assembly of figure 1.
Figure 6 is a bottom view along arrow VI, showing the sliding member of figure 5.
Figure 7 is a front view along arrow VII, showing the sliding member of figure 6.
Figure 8 is a longitudinal cross section of the sliding member of figures 5 to 7, along line VIII-VIII of figure 6, showing in particular the vacuum chamber and the compressed air passages of the sliding member.
Figure 9 is a transversal cross section of this sliding member, along line IX-IX of figures 6 and 8.
Figure 10 is a perspective view, schematically showing the cooperation of the sliding member of figures 5 to 7, with the base table of figures 2 to 4.
Figure 11 is a perspective view, showing from the bottom the sliding member as illustrated on figure 10.
Figures 12 and 13 are end views, at greater scale, of details XII and XIII of figure 10.
Figure 14 is a perspective view, showing a second sliding member which forms part of the high accuracy sliding assembly of figure 1.
Figure 15 is a bottom view along arrow XV, analogous to figure 6, showing the sliding member of figure 14.
Figure 16 is a front view along arrow XVI, analogous to figure 7, showing the sliding member of figure 14.
Figure 17 is a perspective view, analogous to figure 11, schematically showing the cooperation of a sliding member and the base table, which both form part of a sliding assembly according to another embodiment of the invention.
Figure 18 is a transversal cross section of both the sliding member and the base table of figure 17, along line XVIII-XVIII of figure 17.
Figure 19 is a perspective view, showing from the bottom the sliding member as illustrated on figure 17.
Figure 20 is a front view, showing at greater scale a channel which is part of the lift region of the sliding member.
Figure 21 is a longitudinal cross-section, illustrating a channel that is said with compressed air by means of several pipes.
Figure 22 is a longitudinal cross-section, analogous to figure 8, along line XXIV of figure 7.

### Detailed description of the invention

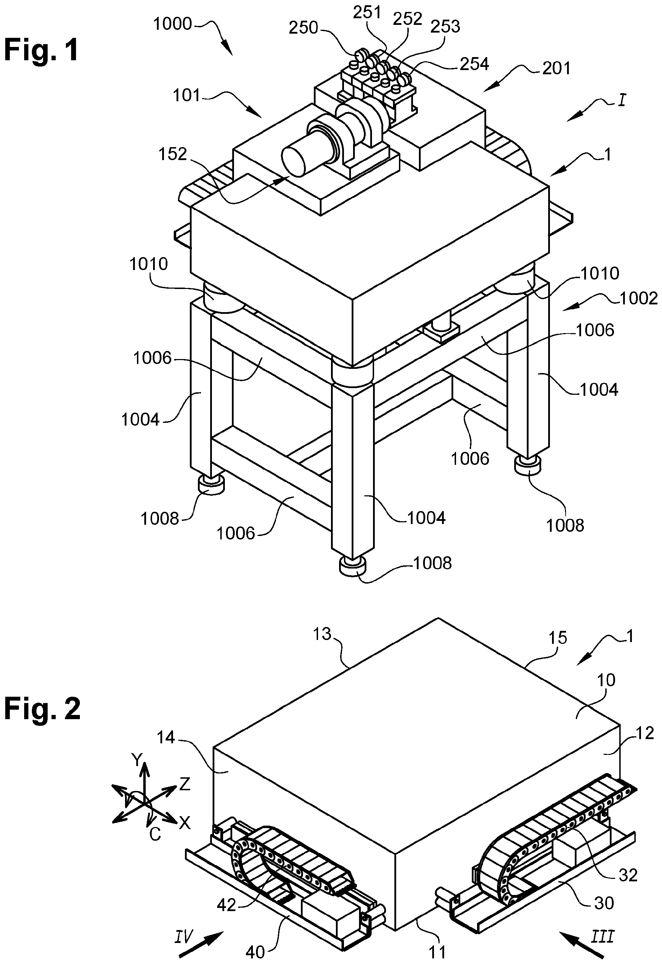

Figure 1 illustrates a manufacturing machine, which is referenced 1000 as a whole. This machine 1000 is first provided with a frame 1002, substantially composed of vertical posts 1004 and horizontal masts 1006 which rest on travelling rollers 1008. Pads 1010 which ensure an anti-vibratory function, are provided at the top of said frame 1002. The mechanical elements 1002 to 1010 listed in the present paragraph are known as such and do not form part of the invention, so that they will not be described in further detail.

This machine 1000 further includes a high accuracy sliding assembly, according to the invention, which is referenced I as a whole. Said sliding assembly essentially comprises a so-called base or reference table 1, as well as a first 101 and a second 201 sliding members. This base table, which is shaped as a parallelepiped, has six surfaces defined with reference to the normal use position:
- opposite upper 10 and lower 11 surfaces, as well as
- peripheral surfaces, namely opposite longitudinal surfaces 12 and 13, as well as opposite transversal surfaces and 14 and 15.

Upper surface 10 defines a so-called reference plane P. Moreover, axes X and Z are noted, which are included into said plane P and are parallel respectively to above defined longitudinal surfaces and transversal surfaces. Y axis is also noted, which is perpendicular to both X and Z.

As will be explained hereafter, the above-mentioned sliding members 101 and 201 are moved along respectively upper surfaces 10 and peripheral surfaces 12, 14 of the table. These motions shall be carried out with a very high accuracy, according to an objective of the invention. In this respect, at least the above surfaces have an outstanding flatness and quality, due to their chosen material as well as to a polishing treatment to which they are submitted.

For what concerns the chosen material, it is advantageously non-porous and has a crystalline structure. According to a particularly advantageous feature of the invention, at least the surfaces 10, 12, 14 of the table 1, which cooperate with the sliding members, are made of Absolute Black Granite. In practice, in view of a convenient manufacturing, the whole table will be made of Absolute Black Granite. This material, which is known as such, is available from different suppliers. So as to render it substantially non-porous, said Absolute Black Granite is advantageously submitted to an appropriate process, in a way known as such, in order to fill its potential pores.

The invention also encompasses a base table, which is made of materials that are different from Absolute Black Granite. In this respect, those skilled in the art may choose materials that have a high stability with respect to both mechanical stresses and temperature variations. By way of examples, glass or silicon carbide may be used. However, Absolute Black Granite is the preferred material, in particular due to its relatively low cost.

According to the invention, at least above-mentioned surfaces 10, 12, 14 of the table 1 are submitted to a so-called optical flatness treatment. Said flatness treatment, which is known as such, is described for example in the following Internet website: https:/len.wikipedia.org/wiki/Optical flat This treatment allows at least a 2 Lambda flatness, advantageously a Lambda/2 flatness, more advantageously a Lambda/4 flatness, where Lambda denotes the wavelength of yellow light, namely 589.3 nanometres. These values of the thus obtained flatness can be controlled by those skilled in the art, according to any appropriate method.

Longitudinal surface 12 of the table is equipped with a U-shaped chute 30, which is fixed thereto by any appropriate means. This chute supports a cable carrier 32, which enables the passage of several cables and air tubes from the sliding member, as will be described hereafter.

Moreover, said surface 12 is provided with a fixed linear motor element 34, which forms a so-called stator. This fixed element 34 extends over a major part of the Z dimension of surface 12. As will be explained in further detail, element 34 is adapted to cooperate with a mobile linear motor element, which is provided on the sliding member. Further, an elongated encoder 36 extends immediately above said fixed element 34. This encoder, which is known as such, makes it possible to control with a very high accuracy the respective positions of the sliding member and the above-mentioned base table.

The transversal face 14 of the table is equipped with similar mechanical elements, as those 30 to 36 described immediately above. In this respect, we note 40 the U-shaped chute, 42 the cable carrier, 44 the fixed linear motor element and 46 the respective encoder.

The high accuracy sliding assembly of the invention also incorporates at least one sliding member. In the present embodiment, two distinct sliding members 101 and 201 are provided, the one being movable along Z direction whereas the other is movable along the X direction. As a variant, the invention also encompasses sliding assemblies which are equipped with one single sliding member. As further variants, three or more sliding members may be provided.

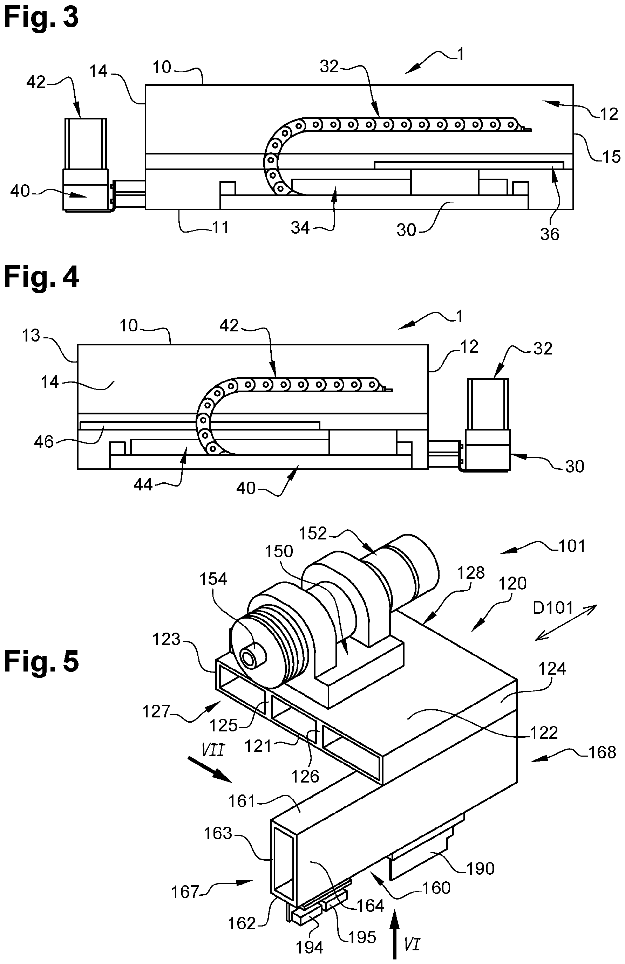

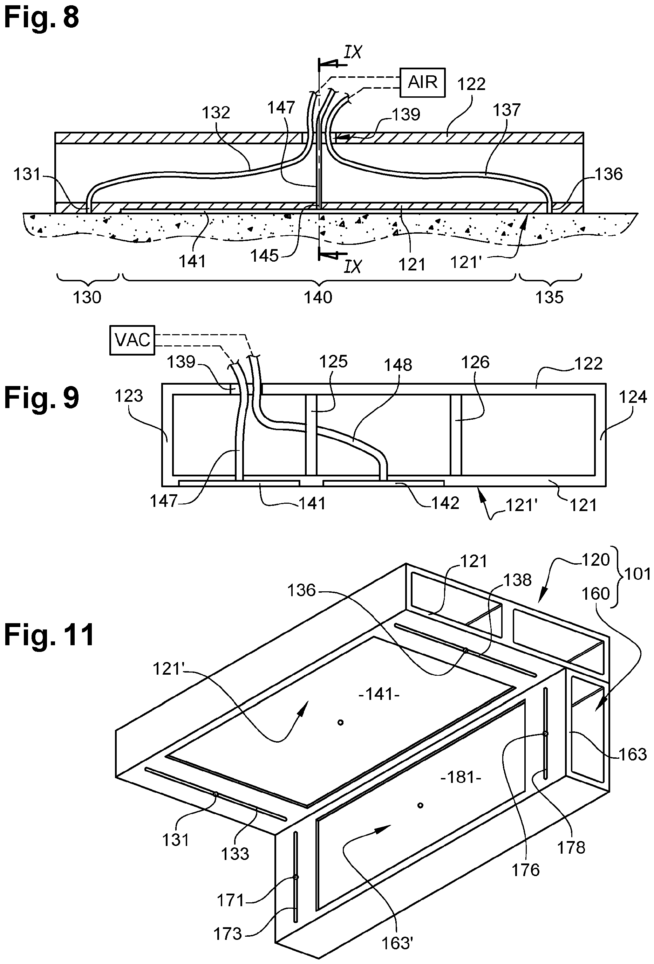

The first sliding member 101 will now be described, in particular with reference to figures 5 to 13. Said sliding member is substantially composed of a so-called load support section 120 and a so-called guiding section 160, which are shown in an isolated manner on figure 11. As will become clearer at reading the following description, load support section is located in use immediately above upper surface of the table, whereas guiding section is located immediately beside peripheral surface of the table. In this first embodiment, guiding section 160 protrudes downwards from a lateral edge of load support section 120. In other words, this sliding member 101, as well as the sliding member 201 described hereunder, are substantially L shaped.

Said load support section 120 is manufactured as a hollow body. With reference to its normal use position, as well as to the motion direction D101 of sliding member 101, the following constitutive parts of this section 120 are noted:
- opposite lower 121 and upper 122 walls
- opposite inner side wall 123 and outer side wall 124, which are respectively adjacent and opposite to table 1
- longitudinal reinforcement ribs 125 and 126, which are mutually parallel and link upper and lower walls.

It is further to be noted that opposite longitudinal ends 127 and 128 of this section 120 are both opened, namely they are not provided with a solid closing.

Said guiding section 160 has a structure, which is substantially similar to that of section 120. In an analogous way, the following constitutive parts of this section 160 are noted
- opposite upper 161 and lower 162 walls
- opposite inner side wall 163 and outer side wall 164, which are respectively adjacent and opposite to table 1.

Opposite longitudinal ends 167 and 168 of section 160 are opened. However, in the present embodiment, section 160 is not provided with ribs since it is not submitted with load.

Advantageously, the chosen material for both sections 120 and 160 is a so-called high-density ceramic, the density of which is typically over 3.6 kg/dm³. The invention also encompasses a sliding member 101 or 201, which is made of materials that are different from a ceramic. In this respect, those skilled in the art may choose materials that have a high stability with respect to both mechanical stresses and temperature variations, while being light and rigid. By way of examples, silicon carbide may be used. However, high density ceramic is the preferred material, in particular due to its weight and stiffness.

Hollow bodies, respectively forming section 120 and 160, are known as such and are commercially available. According to an advantageous embodiment of the invention, these sections are manufactured in a separated manner and are then mutually connected. In particular, these sections are mutually sintered, so as to form the final sliding member 101.

According to an advantageous feature of the invention, at least lower surface 121' of lower wall 121 part of section 120, as well as inner surface 163' of wall 163 part of section 160, are submitted to an optical flatness treatment. Typically, this treatment is substantially analogous to that of table 1, such as above described.

The following numerical values are noted, some of them being referenced on the figures:
- L120, namely length of section 120
- w120, namely width of section 120
- t121: thickness of wall 121, bearing in mind that the thickness of other walls 122 to 124 is analogous
- L160, namely length of section 160
- h160, namely height of section 160
- t161: thickness of wall 161, bearing in mind that the thickness of other walls 162 to 164 is analogous.

Those skilled in the art will be in a position to set the above dimensions of the sliding members, depending upon different parameters. In particular, the dimensions along the longitudinal axis will be adjusted as a function of the load supported by the sliding member. Moreover, the dimensions along the vertical axis will be adjusted to minimise the yaw parameter, in particular as a function of the load and the displacement speed of the sliding member. In the present embodiment, the length of guiding section 160 is superior to that of load support section 120 bearing in mind that, as a variant, the load support section might be longer.

An essential feature of the invention will now be described, in particular with reference to figures 8 to 10. According to this feature, both lower wall 121 and inner wall 163 are divided into three functional regions. Referring to figure 8, lower wall 121 comprises two opposite so-called extremity regions 130 and 135, with reference to the above defined direction D101. In other words, these extremity regions are respectively a front and a rear regions. They are separated by a so-called intermediate region 140. As will become clearer at reading the following description, regions 130 and 135 are lift regions of the load support section 120, whereas region 140 is a pre-load region of section 120.

In each lift region 130, 135, lower wall 121 is drilled with a single passage respectively referenced 131 and 136. At its upstream end, each passage leads to a respective pipe 132, 137. These different pipes, which are schematically shown on the figures, extend through a common hole 139, which is provided in the upper wall 122. At their respective downstream end, passage 131 of region 130 leads to a first channel 133, whereas passage 136 of other region 135 leads to a second channel 138.

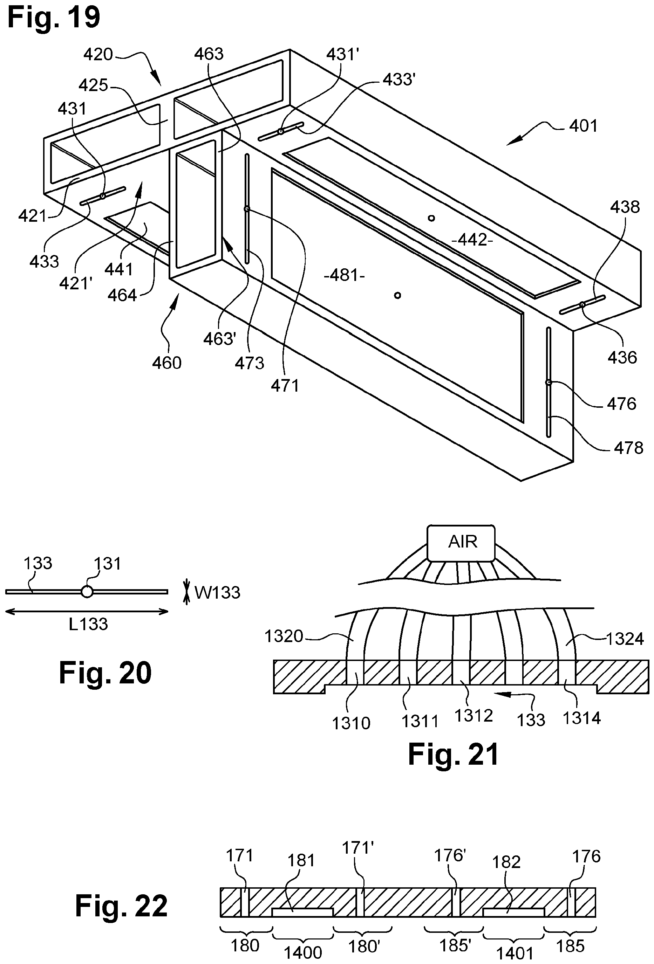

According to a particularly advantageous feature of the invention, each channel is elongated, while extending transversely with respect to the motion of the slider. This elongated shape is illustrated on figure 20, wherein the length L133 and the width W133 of channel 133 are referenced. Advantageously, the ratio (W133/L133) between this width and this length is between 3% and 10%.

In the above embodiment, each channel is fed by one single pipe. In a variant illustrated on figure 21, one given channel may be fed by several pipes, which are provided regularly along the length of this channel. This variant is advantageous, for bringing better regularity in pulse air pressure.

In preload region 140, lower surface 121' of lower wall 121 is provided with recesses, which form cavities 141 and 142. The latter are separated by an arche 143, whereas a solid zone 144 is located on the edge of section 120 which is attached to section 160. The manufacturing of each cavity is carried out in a way known as such. By way of example, the depth of these cavities, respectively noted d141 and d142, is between 1 mm and 5 mm.

The areas of these cavities 141 and 142 are respectively noted S141 and S142.

According to the invention, the global area of these cavities, namely the sum S141 + S142, represents between 40 and 95%, advantageously between 60 and 90% of the whole area S'120 of active surface 120' part of load support section 120. Those skilled in the art will be in a position to modify this proportion, within the above ranges, depending upon several parameters such as those above described, namely the load and the displacement speed. Each cavity leads to a respective passage 145 and 146, drilled in lower wall 121. Said passages lead in turn to pipes are respectively noted 147 and 148, which extend in the above-mentioned hole 139.

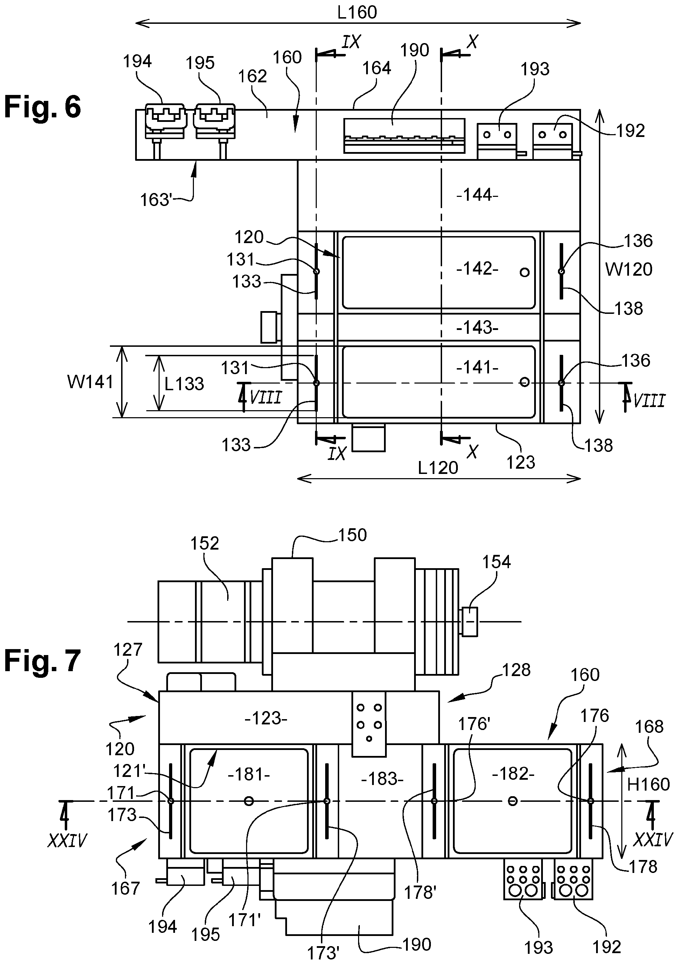

On figure 6 let us note W141 the so-called transverse dimension, with respect to the motion of the slider, of each cavity 141 and 142. Advantageously this dimension is superior to above described length L133 of channel 133, which can also be seen on figure 6. It is to be noted that this length is also a transverse dimension, according to the above definition. The technical effect of this feature allows the compressed air to be equally spread around the channels.

Different pipes 132, 137, 147 and 148 extend outside the hollow body, which forms load support section 120, and are received in the cable sleeve 32. Pipes 132 and 137 lead into a compressed air source AIR shown in particular on figure 8, whereas other pipes 147 and 148 lead into a vacuum source VAC shown in particular on figure 9. Both compressed air source and vacuum source, which are schematically illustrated on the figures, are known as such. The respective values of compressed air and vacuum will be further described, with reference to the implementation method according to the invention.

Load support section 120 is also equipped with functional accessories, which are not part of the invention. In the present embodiment, these accessories make it possible to manufacture optical workpieces. In this respect, they comprise a flange 150, which is fixed to upper wall of load support section 120 by any appropriate means, in particular by screwing into section 120. This flange supports a spindle 152 which is provided with a clamping jaw 154, which is adapted to maintain a not shown workpiece.

As above mentioned, the mechanical structure of guiding section 160 is substantially similar to that of load support section 120. In this respect the mechanical elements of section 160, which are analogous to that of section 120, are given the same references added by number 40. It is to be noted that, in section 160, the two cavities 181 and 182 are located the one behind the other, and not so one beside the other like cavities 141 and 142. Four rows of passages 173, 173', as well as 178, 178' are provided the one behind the other.

As shown on figure 22, the guiding section 160 comprises two end lift regions 180 and 185, like load support section 120. However, the cavities 181 and 182 are provided the one behind the other with respect to the motion direction. Therefore, contrary to load support section, said guiding section 160 comprises two intermediate preload regions 1400 and 1401. Moreover it also comprises two so-called intercalary lift regions 180' and 185', provided in the vicinity of passages 173' and 178'.

Moreover, guiding section is equipped with guiding accessories, which are adapted to cooperate with some mechanical elements provided on table 1. In this respect said section 160 comprises a so-called mobile linear motor member 190, intended to cooperate with the fixed linear motor element 34. In addition, said guiding section is provided with at least one sensor, which is adapted to cooperate with the elongated encoder 36. The present embodiment encompasses two of such sensors, the first one 192 being intended for normal use whereas the other one 193 is intended to a potential emergency use. At last, this guiding section is equipped with two limit switches 194 and 195. The structure and the operation of above elements 190 to 195 are known as such, so that they will not be described in further details.

Sliding member 201 has a structure, which is globally similar to that of above described sliding member 101. In particular it comprises two different sections, namely a load support section 220 and a guiding section 260. More in detail the mechanical elements of sliding member 201, which are analogous to that of sliding member 101, are given the same references added by number 100.

Member 201 differs from that 101, in particular in that its load support section 220 is longer than its guiding section 260, whereas the above-described load support section 120 is shorter than guiding section 160. Load support section 220 is provided with functional accessories, which are tools 250 to 254 shown on figure 1. These tools, which are known as such and thus will not be further described, are intended to the processing of a not shown blank which is received in the spindle 152.

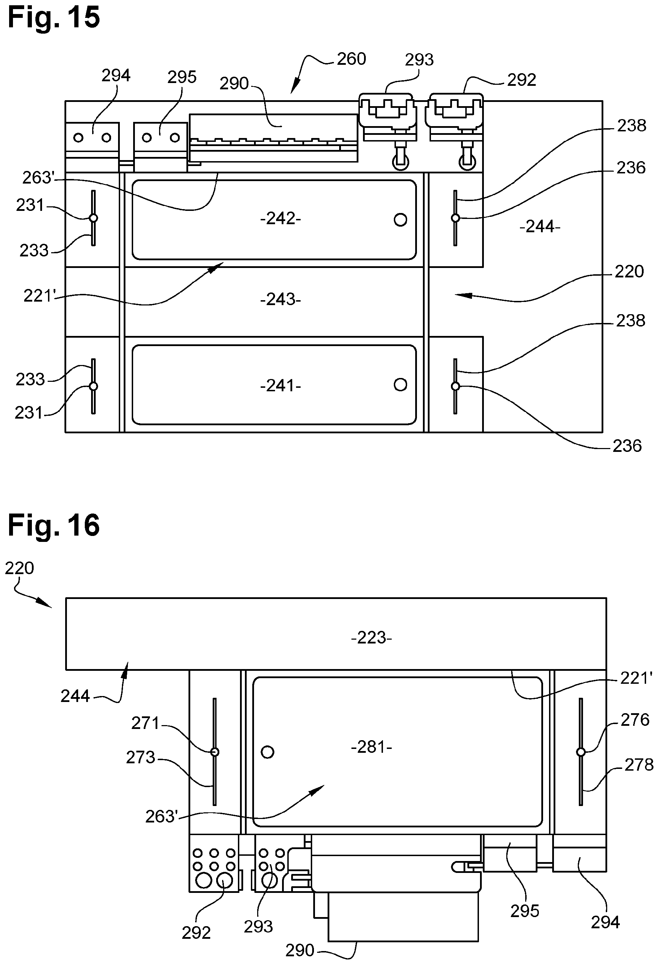

The implementation of sliding member 201 is substantially identical to that of sliding member 101. In particular, as shown on figures 15 and 16, this sliding member 201 is provided with active surfaces 221' and 263'. The latter cooperate with the complementary active surfaces 10' and 14' of the table, in the same manner as the cooperation between active surfaces 121' and 163' with the complementary active surfaces 10' and 12'.

A way of implementing the sliding assembly I according to the invention, as well as the machine 1000 equipped with this sliding assembly, will now be explained. This implementation includes displacing each sliding member 101 and 201, with respect to base table. The displacement of sliding member 101 will now be described, bearing in mind that the displacement of the other sliding member 201 is analogous.

Compressed air is first fed into passages 131 and 136 provided in lower wall 121, as well as into passages 171 and 176 provided in the inner wall 163. As a result, this compressed air leads to lift regions 130 and 135, as well as 180 and 185. Substantially at the same time the vacuum source is actuated, so as to create a vacuum in the cavities 141 and 142, as well as 181 and 182. By way of example, the pressure of this compressed air is between 4 and 6 relative bars. Moreover, the value of the thus created vacuum is between -0.3 bar and -0.5 bar, in particular close to -0.4 relative bar.

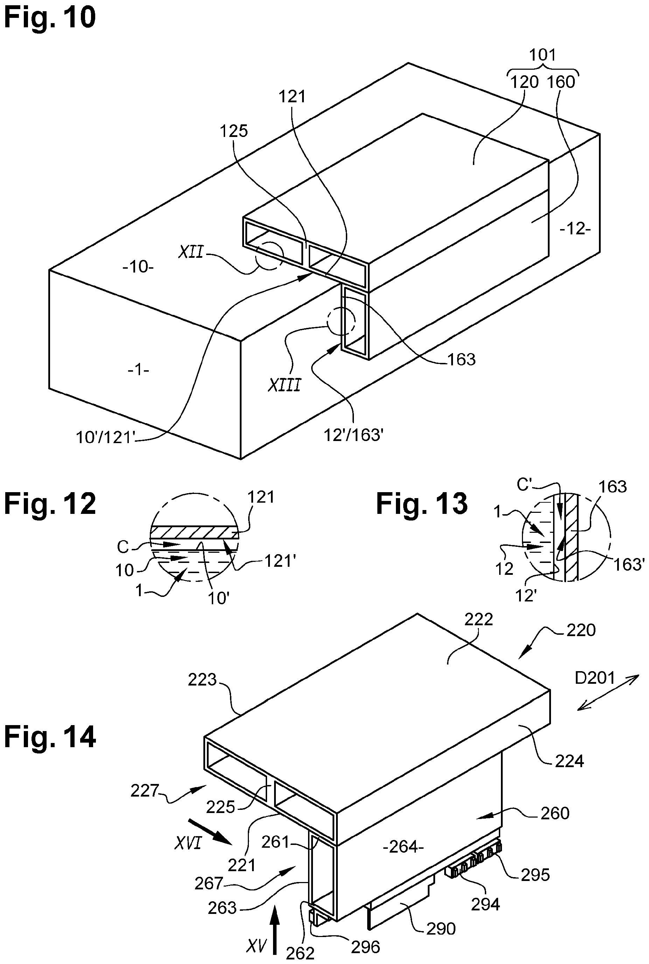

The combination of compressed air injection and vacuum creation, as described above, makes it possible to maintain active surfaces 122' and 163' slightly above complementary active surfaces of the table. As illustrated on figures 12 and 13, clearances C and C' are thus created between each active surface and its respective complementary surface. By way of example, the nominal value of each clearance is between 1 micron and 5 microns.

In an advantageous manner, this clearance value is monitored, in a way known as such. If a measured instantaneous value is outside a predetermined range, the value of at least one of compressed air and vacuum is modified. In practice, the value of compressed air is typically unchanged, whereas the operator may modify the value of the vacuum. In this respect, if the instantaneous measured clearance is too low, the vacuum value is lowered. On the other end, if this measure clearance is too high, then the vacuum value is increased.

Sliding members 101 and 201 are displaced with respect to the table, the one along Z direction and the other along the X direction. As will be further explained, these displacements are carried out with a very high accuracy. The machine 1000 may also be implemented, in a way known as such. In use, the respective motions of two sliding members 101 and 201 is controlled by appropriate electronic means, which are known as such and will not be further described. Once the correct mutual positioning of these members has been reached, one of the tools 250 to 254 is actuated, so as to process the blank held by spindle 152.

The invention brings about several substantial advantages, with respect to previously described prior art.

First it is to be noted that the applicant has identified the drawbacks of prior sliding assemblies, in terms of motion. Indeed, in a typical sliding assembly, the basic mechanical principle is as follows: maintaining the sliding member with a more or less predetermined clearance with respect to the table, so as both to permit its displacement and to avoid any mutual disengagement of this sliding member and of this table. This distance shall be as little as possible, in order to guarantee a high accuracy. However, this distance shall be sufficient to avoid any jamming of the sliding member.

With that in mind, the applicant has shed light on the fact that prior systems are essentially hyperstatic, which constitutes a significant drawback. These prior art systems all use sliding members with at least three active surfaces, which define respective air-stages. Under these circumstances, it is necessary to provide a relatively substantial clearance between these active surfaces of the sliding members and the complementary active surfaces of the table. Thus, providing a thinner clearance between these surfaces would unduly increase the risks of jamming between the sliding member and the table. As a conclusion, the above mentioned substantial clearance might be considered as a necessary feature of prior art, which brings about a poor accuracy. In particular no prior sliding assembly, equipped with air bearings, makes it possible to reach a high accuracy, which could be compared to that provided by oil bearings.

On the contrary, the invention is based on the use of only two active surfaces, provided respectively on the load support section and on the guiding section. This feature makes it possible to render the whole assembly substantially isostatic, which is particularly advantageous with respect to hyperstatic prior art solutions. Indeed, this isostaticity substantially reduces the risks of jamming. Moreover, the sliding member is maintained with respect to table, in a satisfactory manner. In this respect, providing the preload vacuum region guarantees this maintaining, while creating a controlled clearance which enables the required accuracy.

In addition to the provision of the only two active surfaces, such as described immediately above, the invention rests upon also a specific arrangement between lift regions and preload region. Indeed, load support section as well as guiding section are both provided first with two end lift regions, at their opposite ends. Moreover at least one preload region is provided in an intermediate position, also for each of these sections, namely between the above opposite lift regions. This arrangement between said regions, typically formed by channels and at least one cavity, is particularly advantageous since the orthogonal construction of the granite and the slides form an isometrical mechanical assembly.

It is to be noted that this arrangement brings about technical effects with respect to potential alternative arrangements between lift regions and preload regions, which are not part of the invention.

Let us consider a first potential arrangement of a mid-preload region and of a lift region, such as a compressed air nozzle, which is provided at one single end of the slider. Let us also consider a second potential arrangement of a mid-preload region and of opposite lift regions, which are provided on one single section, namely only the load support section or only the guiding section. The above detailed arrangement, according to the invention, has specific advantages with respect to these two potential arrangements which are not functional, in particular due to their lack of stability.

In addition, the transverse elongated shape of the channels makes it possible to strengthen the above technical effects. In particular this shape confers a very high stability to the motion of the slider.

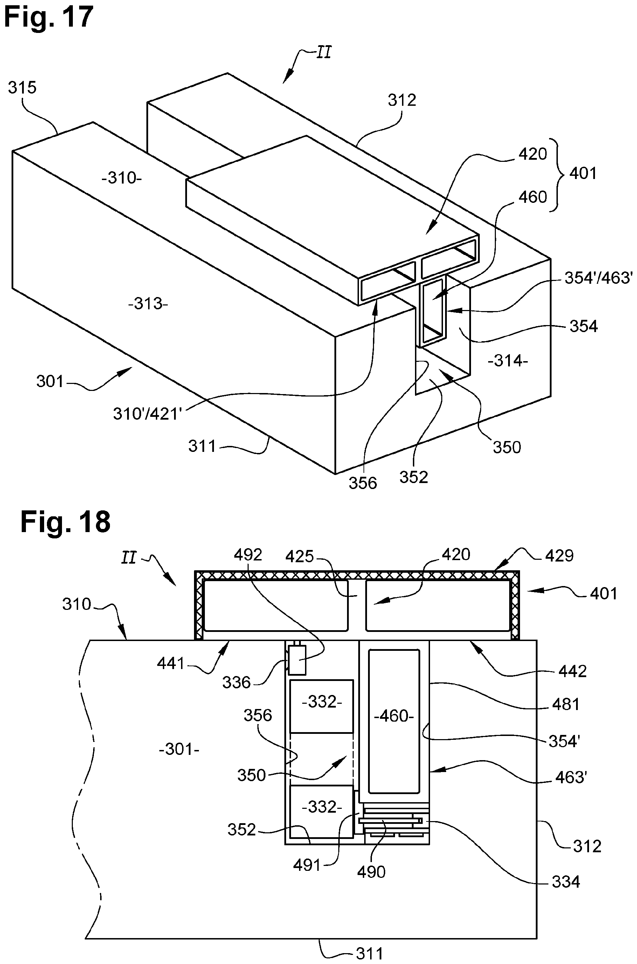

Figures 17 to 19 illustrate a second embodiment of a sliding assembly according to the invention, which is denoted as a whole by reference II. On these figures 17 to 19 the mechanical elements, which are analogous to that of the first embodiment, are given the same references added by number 300.

First the base table 301 of this second embodiment is different from that 1, which has been above described. Indeed, this table 301 is provided with a groove which is denoted as a whole by reference 350. Advantageously, as shown in particular on figure 17, this groove leads to both opposite transversal surfaces 314 and 315, which makes it possible to ease the manufacturing of the groove. However, as not shown variants, this groove may not extend over the whole length of the table. This groove 350 is substantially U shaped, namely it has a horizontal bottom 352, as well as two vertical edges 354 and 356 which connect the upper surface 310.

Moreover, sliding member 401 differs from that 101, in particular in that it is substantially T shaped. Indeed, its guiding section 460 protrudes downwards from a mid-zone of load support section 420. In use, this guiding section is adjacent to one single edge 354 of the groove, whereas it is distant from the other edge 356.

Several accessories, which are part of the sliding assembly are accommodated in this groove. For what concerns the non-mobile assemblies, fixed linear motor element 334 is first provided on a first edge 354 of the groove. Moreover, cable sleeve 332, which is schematically illustrated, is also located in this groove. Finally, encoder 336 is provided on the opposite edge 356.

For what concerns moving assemblies, sensor 492, which is adapted to cooperate with an encoder 336, is fixed onto the lower wall of load support section 420. Moreover, mobile linear motor element 490, which is adapted to cooperate with above-mentioned fixed element 334, is fixed onto lower wall of guiding section, by a connecting plate 491 or analogous.

The implementation of sliding member 401 is substantially similar to that of sliding member 101, as explained here above. On the one hand, the active surface 421' of the load support section 420 slides along the complementary active surface 310' of the table, the same way as above active surfaces 121' and 221' cooperate with complementary active surface 10'. On the other hand, the active surface 463' of the guiding section 460 slides along the complementary active surface 354' of the table, the same way as above active surfaces 163' and 263' cooperate with respective complementary active surfaces 12' and 14'.

In the present description, two different embodiments of the invention have been detained. Each of these embodiments bring about specific advantages.

The first embodiment, which incorporates an L shaped sliding member, permits the use of a parallelepiped base table. Therefore, this embodiment makes it possible to ease the manufacturing of this table.

The second embodiment incorporates a T shaped sliding member, which is located at a close vicinity with respect to the gravity center of the base table. This makes it possible to reduce the global length of the sliding member. Moreover, the groove, provided in the table, enables the reception of accessories which are part of the sliding assembly. Under these circumstances, the global dimensions of this assembly are reduced. Moreover, the accessories accommodated in this groove benefit of a higher protection, in particular with respect to potential external impacts. In this respect, the load support section 420 may be covered with a protecting bellow 429, of any appropriate type.

Providing a horizontal load support section, combined with a vertical guiding section, is an especially advantageous feature of the invention. As this has been mentioned above, this makes it possible to independently set the dimensions of these sections, so as to control respectively the load and the yaw parameters. In particular, one of these sections might be either shorter or longer than the other one. In this respect emphasis shall be laid on the fact that, in prior art, no sliding member is equipped with two different sections which respectively extend horizontally and vertically. Moreover none of these prior sliding members is equipped with sections, the respective lengths thereof are different.

Let us finally emphasise a particularly advantageous feature of the invention. As shown on the different described embodiments, on each longitudinal side, with respect to the motion of the slider, each cavity is associated with one single transversal channel. This feature may apply for different arrangements:
- on figure 6, two cavities 141 and 142, positioned side-by-side, each provided with one single left channel 133 and with one single right channel 138;
- on figure 7, two cavities 181 and 182 positioned the one behind the other, 181 being provided with one single left channel 173 and with one single right channel 173', whereas 182 is provided with one single left channel 178' and with one single right channel 178,
- on figure 15, an arrangement which is similar to figure 6 : two cavities 241 and 242, positioned side-by-side, each provided with one single left channel 233 and with one single right channel 238;
- on figure 16, one single cavity 281 with one single left channel 273 and one single right channel 278;
- on figure 19, an arrangement which is similar to figures 6 and 15 : two cavities 441 and 442, positioned side-by-side, each provided with one single left channel 433 and with one single right channel 438;
- on figure 19, one single cavity 481 with one single left channel 473 and one single right channel 478.

This combination, for each cavity, between said cavity and two transversal channels on either side, brings about significant advantages with respect to stability of the motion. In particular it substantially avoids any vibrations, compared to other embodiments.

## Claims

1. A sliding assembly (I; II), in particular for a manufacturing machine, said machine being intended to manufacture workpieces, such as optical workpieces, as mirrors, lenses, contact lenses or intraocular lenses,
said sliding assembly comprising:
- a base table (1; 301)
- at least one sliding member (101, 201; 401) which is movable with respect to said table,
- moving means (34, 44, 190; 334, 490) adapted to move each said sliding member with respect to said table,
**characterised in that**
each sliding member is provided with only one single so-called first active surface (121'; 421') and one single so-called second (163'; 463') active surface, said single first active surface and said single second active surface being mutually perpendicular, said sliding member comprising
- a load support section (120; 420) being provided on the first active surface, said load support section being adapted to slide along a first complementary active surface (10'; 310') of said table, in particular an upper surface of said table and
- a guiding section (160; 460) being provided on the second active surface, guiding section being adapted to slide along a second complementary active surface (12'; 354') of said table, in particular a peripheral surface of the table, said second complementary active surface being located in use underneath said first complementary active surface
each of said load support section and guiding section comprising, with reference to the motion direction of the sliding member along the table
- a first extremity lift region (130; 180) being provided at a first extremity of said section (120 or 160), as well as an opposite extremity lift region (135; 185), being provided at the opposite extremity of said section, each lift region being adapted to be connected to a compressed air source (AIR)
- at least one intermediate preload region (140; 1400, 1401), being provided between said opposite extremity lift regions, each preload region being adapted to be connected to a vacuum source (VAC), wherein said intermediate preload region comprises at least one cavity (141,142; 441,442) provided in the active surface, said cavity being adapted to be connected to said vacuum source, and wherein the total area (S141+S142) of said cavity(ies) is between 40 and 95 % of the total area of said active surface which is provided with said cavity(ies).

2. A sliding assembly according to preceding claim wherein, in use, said load support section and said first active surface extend both horizontally, so as to be dimensioned in order to control the load, whereas said guiding section and said second active surface extend both vertically, so as to be dimensioned in order to control the yaw.

3. A sliding assembly according to any preceding claim, wherein each lift region comprises at least one air diffusion channel (133,138; 433,438), said air diffusion channel being adapted to be connected with the compressed air source, each air diffusion channel being elongated and extending transversely with reference to the motion direction of the sliding member along the table.

4. A sliding assembly according to preceding claim, wherein the ratio between the width (W133) of the channel and the length (L133) of said channel is between 3% and 10%, in particular between 3% and 5%.

5. A sliding assembly according to claim 3 or 4, wherein said lift region comprises at least one passage (131) which leads into said channel (133), said passage being adapted to receive a pipe for connection to the compressed air source, in particular several passages (1130 - 1334) which are provided regularly along the length of one single channel.

6. A sliding assembly according to any preceding claim, wherein the depth of each cavity is between 1 mm and 5 mm.

7. A sliding assembly according to any preceding claim, wherein the total area (S141+S142) of said cavity(ies) is between 60 and 90 % of the total area of said active surface which is provided with said cavity(ies).

8. A sliding assembly according to any of claims 3 to 5, in combination with claim 6 or 7, wherein the transverse dimension (W141), with respect to the motion direction, of each cavity is superior to the transverse dimension (L133) of each channel.

9. A sliding assembly according to any preceding claim, comprising at least two preload regions (1400, 1401) the one behind the other with respect to the motion direction, as well as at least one intercalary lift region (180', 185') provided between said preload regions, each intercalary lift region comprising one single diffusion channel (173', 178').

10. A sliding assembly according to any preceding claim, wherein at least the active surfaces of both load support section and guiding section, as well as the complementary active surfaces of base table, are optically polished, and wherein said sliding member is made of optical flatness ceramic, in particular a substantially non-porous ceramic and/or wherein at least the active surfaces of the tables are made of substantially nonporous Absolute Black Granite.

11. A sliding assembly according to any preceding claim, wherein said moving means comprise a fixed linear motor element (34,334) provided on one of said base table and said sliding member, as well as a mobile linear motor element (190; 490) provided on the other of said base table and said sliding member, said assembly further comprising positioning means adapted to control the mutual position of sliding member with respect to the base table, said positioning means comprising in particular an encoder provided on one of said base table and said sliding member, as well as a sensor provided on the other of said base table and said sliding member.

12. A sliding assembly according to any claims 3 to 11 wherein, on either side of each cavity, with respect to the motion direction, one single air diffusion channel is provided (141 - 133,138 ; 142 - 133,138 ; 181 - 173,173'; 182 -178,178'; 241 - 233,238 ; 242 - 233,238 ; 442 - 433,438 ; 481 - 473,478).

13. A sliding assembly according to any preceding claim, wherein said sliding member (101, 201) is L shaped, said guiding section (160) protruding from a lateral edge of load support section (120), or wherein said sliding member (401) is T shaped, said guiding section (460) protruding from a mid-part of load support section (420).

14. A sliding assembly according to claim 13, wherein said guiding section is at least partly received in a groove (350) provided in said base table, said groove accommodating at least one further accessory of said guiding assembly, such as at least part of moving means, at least part of positioning means, at least part of a cable sleeve.

15. A manufacturing machine for manufacturing workpieces, in particular optical workpieces, said machine comprising a frame, a sliding assembly (I; II) according to any preceding claim, which is mounted on said frame, as well as manufacturing means mounted on said sliding assembly,
wherein said sliding assembly comprises
- a first sliding member (101) which is movable with respect to said table, along a first Z direction, said first sliding member being provided with support means adapted to support workpieces;
- a second sliding member (201) which is movable with respect to said table, along a second X direction, which is in particular perpendicular with respect to said first direction, said second sliding member being provided with at least one manufacturing tool; and
- possibly a vertical sliding member which is movable with respect to said table, along a third Y direction, which is in particular perpendicular with respect to said first direction, said third sliding element being provided with at least one manufacturing tool.

## Patentansprüche

1. Gleitanordnung (I; II), insbesondere für eine Fertigungsmaschine, wobei die Maschine dazu bestimmt ist, Werkstücke, wie optische Werkstücke, wie Spiegel, Gläser, Kontaktlinsen oder Intraokularlinsen, zu fertigen,
wobei die Gleitanordnung umfasst:
- einen Grundtisch (1; 301)
- mindestens ein Gleitelement (101, 201; 401), welches in Bezug auf den Tisch beweglich ist,
- Bewegungsmittel (34, 44, 190; 334, 490), die angepasst sind, um jedes Gleitelement in Bezug auf den Tisch zu bewegen,
**dadurch gekennzeichnet, dass**
jedes Gleitelement mit nur einer einzigen sogenannten ersten aktiven Oberfläche (121`; 421') und einer einzigen sogenannten zweiten (163'; 463') aktiven Oberfläche versehen ist, wobei die einzige erste aktive Oberfläche und die einzige zweite aktive Oberfläche senkrecht zueinander sind, wobei das Gleitelement umfasst
- einen Lastenträgerabschnitt (120; 420), der an der ersten aktiven Oberfläche vorgesehen ist, wobei der Lastenträgerabschnitt angepasst ist, um entlang einer ersten ergänzenden aktiven Oberfläche (10'; 310') des Tisches, insbesondere einer oberen Oberfläche des Tisches zu gleiten, und
- einen Führungsabschnitt (160; 460), der an der zweiten aktiven Oberfläche vorgesehen ist, wobei der Führungsabschnitt angepasst ist, um entlang einer zweiten ergänzenden aktiven Oberfläche (12'; 354') des Tisches, insbesondere einer Umfangsoberfläche des Tisches zu gleiten, wobei sich die zweite ergänzende aktive Oberfläche im Gebrauch unterhalb der ersten ergänzenden aktiven Oberfläche befindet
wobei jeder von dem Lastenträgerabschnitt und Führungsabschnitt in Bezug auf die Bewegungsrichtung des Gleitelements entlang des Tisches Folgendes umfasst
- einen Hebebereich für ein erstes Ende (130; 180), der an einem ersten Ende des Abschnitts (120 oder 160) vorgesehen ist, sowie einen Hebebereich für ein gegenüberliegendes Ende (135; 185), der an dem gegenüberliegenden Ende des Abschnitts vorgesehen ist, wobei jeder Hebebereich angepasst ist, um mit einer Druckluftquelle (AIR) verbunden zu werden
- mindestens einen Vorspannzwischenbereich (140; 1400, 1401), der zwischen den Hebebereichen gegenüberliegender Enden vorgesehen ist, wobei jeder Vorspannbereich angepasst ist, um mit einer Vakuumquelle (VAC) verbunden zu werden, wobei der Vorspannzwischenbereich mindestens einen Hohlraum (141, 142; 441, 442) umfasst, der in der aktiven Oberfläche vorgesehen ist, wobei der Hohlraum angepasst ist, um mit der Vakuumquelle verbunden zu werden, und wobei die Gesamtfläche (S141+S142) des (der) Hohlraumes (Hohlräume) zwischen 40 und 95% der Gesamtfläche der aktiven Oberfläche ausmacht, die mit dem (den) Hohlraum (Hohlräumen) versehen ist.

2. Gleitanordnung nach dem vorstehenden Anspruch, wobei sich der Lastenträgerabschnitt und die erste aktive Oberfläche im Gebrauch beide horizontal erstrecken, um derart bemessen zu sein, um die Last zu steuern, während sich der Führungsabschnitt und die zweite aktive Oberfläche beide vertikal erstrecken, um bemessen zu sein, um die Gierung zu steuern.

3. Gleitanordnung nach einem vorstehenden Anspruch, wobei jeder Hebebereich mindestens einen Luftverteilungskanal (133, 138; 433, 438) umfasst, wobei der Luftverteilungskanal angepasst ist, um mit der Druckluftquelle verbunden zu werden, wobei jeder Luftverteilungskanal langgestreckt ist, und sich in Bezug auf die Bewegungsrichtung des Gleitelements entlang des Tisches querlaufend erstreckt.

4. Gleitanordnung nach dem vorstehenden Anspruch, wobei das Verhältnis zwischen der Breite (W133) des Kanals und der Länge (L133) des Kanals zwischen 3% und 10%, insbesondere zwischen 3% und 5% liegt.

5. Gleitanordnung nach Anspruch 3 oder 4, wobei der Hebebereich mindestens einen Durchlass (131) umfasst, der in den Kanal (133) führt, wobei der Durchlass angepasst ist, um ein Rohr zur Verbindung mit der Druckluftquelle aufzunehmen, insbesondere mehrere Durchlässe (1130-1334), die regelmäßig entlang der Länge eines einzigen Kanals vorgesehen sind.

6. Gleitanordnung nach einem vorstehenden Anspruch, wobei die Tiefe eines jeden Hohlraumes zwischen 1 mm und 5 mm liegt.

7. Gleitanordnung nach einem vorstehenden Anspruch, wobei die Gesamtfläche (S141+S142) des (der) Hohlraumes (Hohlräume) zwischen 60 und 90% der. Gesamtfläche der aktiven Oberfläche ausmacht, die mit dem (den) Hohlraum (Hohlräumen) versehen ist.

8. Gleitanordnung nach einem der Ansprüche 3 bis 5, in Kombination mit Anspruch 6 oder 7, wobei die Querabmessung (W141) in Bezug auf die Bewegungsrichtung eines jeden Hohlraumes größer als die Querabmessung (L133) eines jeden Kanals ist.

9. Gleitanordnung nach einem vorstehenden Anspruch, mindestens zwei Vorspannbereiche (1400, 1401), die eine hinter der anderen, in Bezug auf die Bewegungsrichtung, sowie mindestens einen eingeschobenen Hebebereich (180'; 185') umfassend, der zwischen den Vorspannbereichen vorgesehen ist, wobei jeder eingeschobene Hebebereich einen einzigen Verteilungskanal (173'; 178') umfasst.

10. Gleitanordnung nach einem vorstehenden Anspruch, wobei mindestens die aktiven Oberflächen von beiden, dem Lastenträgerabschnitt und Führungsabschnitt, sowie die ergänzenden aktiven Oberflächen des Grundtisches optisch poliert sind, und wobei das Gleitelement aus Keramik mit optischer Ebenheit, insbesondere einer im Wesentlichen nicht porösen Keramik gefertigt ist, und/oder wobei mindestens die aktiven Oberflächen der Tische aus im Wesentlichen nicht porösem tiefschwarzem Granit gefertigt sind.

11. Gleitanordnung nach einem vorstehenden Anspruch, wobei die Bewegungsmittel eine fixiertes Linearmotorelement (34, 334) umfassen, das an einem von dem Grundtisch und dem Gleitelement vorgesehen ist, sowie ein bewegliches Linearmotorelement (190; 490), das an dem anderen von dem Grundtisch und dem Gleitelement vorgesehen ist, wobei die Anordnung weiter Positioniermittel umfasst, die angepasst sind, um die gegenseitige Position eines Gleitelements in Bezug auf den Grundtisch zu steuern, wobei die Positioniermittel insbesondere einen Geber umfassen, der an einem von dem Grundtisch und dem Gleitelement vorgesehen ist, sowie einen Sensor, der an dem anderen von dem Grundtisch und dem Gleitelement vorgesehen ist.

12. Gleitanordnung nach einem der Ansprüche 3 bis 11, wobei an jeder Seite eines jeden Hohlraumes in Bezug auf die Bewegungsrichtung ein einziger Luftverteilungskanal vorgesehen (141-133, 138; 142-133,138; 181-173;173'; 182-178; 178'; 241-233, 238; 242-233; 238; 442-433, 438; 481-473,478) ist.

13. Gleitanordnung nach einem vorstehenden Anspruch, wobei das Gleitelement (101, 201) L-förmig ist, der Führungsabschnitt (160) aus einer Seitenkante des Lastenträgerabschnitts (120) hervorsteht, oder wobei das Gleitelement (401) T-förmig ist, der Führungsabschnitt (460) aus einem Mittelteil des Lastenträgerabschnitts (420) hervorsteht.

14. Gleitanordnung nach Anspruch 13, wobei der Führungsabschnitt mindestens teilweise in einer Nut (350) aufgenommen ist, die in dem Grundtisch vorgesehen ist, wobei die Nut mindestens ein weiteres Zubehörteil der Führungsanordnung, wie mindestens einen Teil von Bewegungsmitteln, mindestens einen Teil von Positioniermitteln, mindestens einen Teil einer Kabelmuffe aufnimmt.

15. Fertigungsmaschine zur Fertigung von Werkstücken, insbesondere optischen Werkstücken, wobei die Maschine ein Gestell, eine Gleitanordnung (I; II) nach einem vorstehenden Anspruch, die auf dem Gestell montiert ist, sowie Fertigungsmittel, die an der Gleitanordnung montiert sind, umfasst,
wobei die Gleitanordnung umfasst
- ein erstes Gleitelement (101), welches in Bezug auf den Tisch entlang einer ersten Z-Richtung beweglich ist, wobei da erste Gleitelement mit Trägermitteln vorgesehen ist, die angepasst sind, um Werkstücke zu tragen;
- ein zweites Gleitelement (201), welches in Bezug auf den Tisch entlang einer zweiten X-Richtung beweglich ist, welche insbesondere in Bezug auf die erste Richtung senkrecht ist, wobei das zweite Gleitelement mit mindestens einem Fertigungswerkzeug vorgesehen ist; und
- möglicherweise ein vertikales Gleitelement, welches in Bezug auf den Tisch entlang einer dritten Y-Richtung beweglich ist, welche insbesondere in Bezug auf die erste Richtung senkrecht ist, wobei das dritte Gleitelement mit mindestens einem Fertigungswerkzeug vorgesehen ist.

## Revendications

1. Ensemble coulissant (I ; II), en particulier pour une machine à usiner, ladite machine étant destinée à usiner des pièces, telles que des pièces optiques, comme des miroirs, des verres, des lentilles de contact ou des lentilles intraoculaires,
ledit ensemble coulissant comprenant :
- une table de base (1 ; 301)
- au moins un organe coulissant (101, 201 ; 401) qui peut être déplacé par rapport à ladite table,
- des moyens de déplacement (34, 44, 190 ; 334, 490) adaptés pour déplacer chaque dit organe coulissant par rapport à ladite table,
**caractérisé en ce que**
chaque organe coulissant est doté seulement d'une unique surface appelée première surface active (121' ; 421') et d'une unique surface appelée deuxième surface active (163' ; 463'), ladite unique première surface active et ladite unique deuxième surface active étant mutuellement perpendiculaires, ledit organe coulissant comprenant
- une section de support de charge (120 ; 420) qui est prévue sur la première surface active, ladite section de support de charge étant adaptée pour coulisser le long d'une première surface active complémentaire (10' ; 310') de ladite table, en particulier une surface supérieure de ladite table et
- une section de guidage (160 ; 460) qui est prévue sur la deuxième surface active, la section de guidage étant adaptée pour coulisser le long d'une deuxième surface active complémentaire (12' ; 354') de ladite table, en particulier une surface périphérique de la table, ladite deuxième surface active complémentaire étant située en utilisation en dessous de ladite première surface active complémentaire
chacune desdites section de support de charge et section de guidage comprenant, en référence à la direction de déplacement de l'organe coulissant le long de la table
- une première région de levage d'extrémité (130 ; 180) qui est prévue à une première extrémité de ladite section (120 ou 160), ainsi qu'une région de levage d'extrémité opposée (135 ; 185), qui est prévue à l'extrémité opposée de ladite section, chaque région de levage étant adaptée pour être reliée à une source d'air comprimé (AIR)
- au moins une région de précharge intermédiaire (140 ; 1400, 1401), qui est prévue entre lesdites régions de levage d'extrémité opposée, chaque région de précharge étant adaptée pour être reliée à une source de vide (VAC), dans lequel ladite région de précharge intermédiaire comprend au moins une cavité (141, 142 ; 441, 442) prévue dans la surface active, ladite cavité étant adaptée pour être reliée à ladite source de vide, et dans lequel la superficie totale (S141 + S142) de ladite ou desdites cavités est entre 40 et 95 % de la superficie totale de ladite surface active qui est dotée de ladite ou desdites cavités.

2. Ensemble coulissant selon la revendication précédente dans lequel, en utilisation, ladite section de support de charge et ladite première surface active s'étendent toutes deux horizontalement, de manière à être dimensionnées afin de réguler la charge, alors que ladite section de guidage et ladite deuxième surface active s'étendent toutes deux verticalement, de manière à être dimensionnées afin de réguler le lacet.

3. Ensemble coulissant selon une quelconque revendication précédente, dans lequel chaque région de levage comprend au moins un canal de diffusion d'air (133, 138 ; 433, 438), ledit canal de diffusion d'air étant adapté pour être relié à la source d'air comprimé, chaque canal de diffusion d'air étant allongé et s'étendant transversalement en référence à la direction de déplacement de l'organe coulissant le long de la table.

4. Ensemble coulissant selon une revendication précédente, dans lequel le rapport entre la largeur (W133) du canal et la longueur (L133) dudit canal est entre 3 % et 10 %, en particulier entre 3 % et 5 %.

5. Ensemble coulissant selon la revendication 3 ou 4, dans lequel ladite région de levage comprend au moins un passage (131) qui mène dans ledit canal (133), ledit passage étant adapté pour recevoir un tuyau pour une liaison à la source d'air comprimé, en particulier plusieurs passages (1130 - 1334) qui sont prévus de manière régulière le long de la longueur d'un unique canal.

6. Ensemble coulissant selon une quelconque revendication précédente, dans lequel la profondeur de chaque cavité est entre 1 mm et 5 mm.

7. Ensemble coulissant selon une quelconque revendication précédente, dans lequel la superficie totale (S141 + S142) de ladite ou desdites cavités est entre 60 et 90 % de la superficie totale de ladite surface active qui est dotée de ladite ou desdites cavités.

8. Ensemble selon l'une quelconque des revendications 3 à 5, en association avec la revendication 6 ou 7, dans lequel la dimension transversale (W141), par rapport à la direction de déplacement, de chaque cavité est supérieure à la dimension transversale (L133) de chaque canal.

9. Ensemble coulissant selon une quelconque revendication précédente, comprenant au moins deux régions de précharge (1400, 1401) l'une derrière l'autre par rapport à la direction de déplacement, ainsi qu'au moins une région de levage intercalaire (180', 185') prévue entre lesdites régions de précharge, chaque région de levage intercalaire comprenant un unique canal de diffusion (173', 178').

10. Ensemble coulissant selon une quelconque revendication précédente, dans lequel au moins les surfaces actives d'à la fois la section de support de charge et la section de guidage, ainsi que les surfaces actives complémentaires de la table de base, sont polies optiquement, et dans lequel ledit organe coulissant est fait de céramique pour plan optique, en particulier de céramique sensiblement non poreuse et/ou dans lequel au moins les surfaces actives des tables sont faites de granite noir absolu sensiblement non poreux.

11. Ensemble coulissant selon une quelconque revendication précédente, dans lequel lesdits moyens de déplacement comprennent un élément moteur linéaire fixe (34, 334) prévu sur l'un de ladite table de base et dudit organe coulissant, ainsi qu'un élément moteur linéaire mobile (190 ; 490) prévu sur l'autre de ladite table de base et dudit organe coulissant, ledit ensemble comprenant en outre des moyens de positionnement adaptés pour réguler la position mutuelle de l'organe coulissant par rapport à la table de base, lesdits moyens de positionnement comprenant en particulier un encodeur prévu sur l'un de ladite table de base et dudit organe coulissant, ainsi qu'un capteur prévu sur l'autre de ladite table de base et dudit organe coulissant.

12. Ensemble coulissant selon l'une quelconque des revendications 3 à 11 dans lequel, sur l'un ou l'autre côté de chaque cavité, par rapport à la direction de déplacement, un unique canal de diffusion d'air est prévu (141 - 133, 138 ; 142 - 133, 138 ; 181 - 173, 173' ; 182 - 178, 178' ; 241 - 233, 238 ; 242 - 233, 238 ; 442 - 433, 438 ; 481 - 473, 478).

13. Ensemble coulissant selon une quelconque revendication précédente, dans lequel ledit organe coulissant (101, 201) est en forme de L, ladite section de guidage (160) faisant saillie depuis un bord latéral de la section de support de charge (120), ou dans lequel ledit organe coulissant (401) est en forme de T, ladite section de guidage (460) faisant saillie depuis une partie médiane de section de support de charge (420).

14. Ensemble coulissant selon la revendication 13, dans lequel ladite section de guidage est au moins partiellement reçue dans une rainure (350) prévue dans ladite table de base, ladite rainure accueillant au moins un accessoire supplémentaire dudit ensemble de guidage, tel qu'au moins une partie de moyens de déplacement, au moins une partie de moyens de positionnement, au moins une partie d'un manchon de câble.

15. Machine à usiner pour usiner des pièces, en particulier des pièces optiques, ladite machine comprenant un bâti, un ensemble coulissant (I ; II) selon une quelconque revendication précédente, qui est monté sur ledit bâti, ainsi que des moyens d'usinage montés sur ledit ensemble coulissant,
dans laquelle ledit ensemble coulissant comprend
- un premier organe coulissant (101) qui peut être déplacé par rapport à ladite table, le long d'une première direction Z, ledit premier organe coulissant étant doté de moyens de support adaptés pour supporter des pièces ;
- un deuxième organe coulissant (201) qui peut être déplacé par rapport à ladite table, le long d'une deuxième direction X, qui est en particulier perpendiculaire par rapport à ladite première direction, ledit deuxième organe coulissant étant doté d'au moins un outil d'usinage ; et
- éventuellement un organe coulissant vertical qui peut être déplacé par rapport à ladite table, le long d'une troisième direction Y, qui est en particulier perpendiculaire par rapport à ladite première direction, ledit troisième organe coulissant étant doté d'au moins un outil d'usinage.
